# FASCICULE DE BREVET EUROPEEN

(11) **EP 2 315 340 B1**
(45) Date de publication et mention de la délivrance du brevet: **29.03.2017**
(21) Numéro de dépôt: 10187011.1
(22) Date de dépôt: 08.10.2010
(51) Int. Cl.: H02K 11/04, H05K 7/20

(54) **Module de redressement de courant pour machine électrique tournante et machine électrique tournante comportant un tel module**
Gleichrichtermodul für elektrische Maschine und elektrische Maschine mit einem solchen Modul
Current rectifier module for rotating electric machine and rotating electric machine comprising such a module

(30) Priorité: 26.10.2009 FR 0957476
(43) Date de publication de la demande: 27.04.2011
(73) Titulaire: VALEO EQUIPEMENTS ELECTRIQUES MOTEUR, 94056 Créteil Cedex (FR)
(72) Inventeur: Tunzini, Marc, 78000 Versailles (FR); Seidenbinder, Régis, 94600 Choisy Le Roi (FR); Tauvron, Fabrice, 91200 Athis-Mons (FR)
(74) Mandataire: de Lambilly Delorme, Marie Pierre

(56) Documents cités:
- EP-A1- 0 531 197
- WO-A2-2009/024709
- FR-A1- 2 856 944
- FR-A1- 2 911 444

## Description

### Domaine de l'invention

La présente invention concerne un module de redressement de courant pour machine électrique tournante polyphasée, notamment un alternateur ou un alterno-démarreur de véhicule automobile, et une machine électrique tournante comportant un tel module

### Etat de la technique

Un tel module est une telle machine polyphasée, sous la forme d'un alternateur ou d'un alterno-démarreur polyphasé à ventilation interne pour véhicule automobile, sont décrits dans le document FR 2 911 444 conforme au préambule de la revendication 1.

Dans ce document la machine comporte de manière conventionnelle, par exemple comme dans les document EP 515 259 et FR 2 602 925, un carter portant un stator entourant un rotor, tel qu'un rotor à griffes, solidaire d'un arbre de rotor monté rotatif dans le carter.

Le carter comporte au moins deux flasques ajourés, appelées palier avant et palier arrière, de forme annulaire et creuse, portant chacun centralement un roulement à billes pour montage rotatif de l'arbre.

Au moins un bobinage d'excitation est associé au rotor. Ce bobinage est par exemple relié par des liaisons filaires à des bagues collectrices solidaires de l'extrémité arrière de l'arbre du rotor. Des balais, portés par un porte-balais solidaire d'un régulateur de tension, sont admis à frotter sur les bagues.

Le stator comporte un corps rainuré portant un bobinage de stator traversant les rainures et s'étendant de part et d'autre du corps pour former des chignons.

Le bobinage de stator comporte un ou plusieurs enroulements par phase. Ces enroulements sont obtenus par exemple à partir d'un fil continu bobiné recouvert d'émail ou à partir de segments conducteurs recouverts d'émail, tels que des épingles reliées entre elles par soudage.

Les enroulements sont connectés en étoile ou en triangle et présentent des sorties reliées à des entrées appartenant à un dispositif de redressement de courant, d'une part, porté par l'un des paliers avant et arrière et, d'autre part, comportant des éléments de redressement de courant, tels que des diodes, appartenant à au moins un pont redresseur de courant alternatif en courant continu. Ce dispositif est coiffé par un capot de protection ajouré solidaire du palier.
Le nombre de phases dépend des applications. Il est égal ou supérieur à trois comme décrit dans le document WO 03/009452, avec présence de un ou deux ponts redresseurs.

Ainsi en se référant aux figures 1 et 2, qui correspondent aux figures 3 et 6 du document FR 2 911 444, on voit que le palier arrière 50, de forme annulaire et creuse, comporte un fond 56, globalement d'orientation transversale par rapport à l'axe X-X de l'arbre 61 du rotor 58, ici à griffes, portant un ventilateur arrière 57 muni de pales 570. Le fond 56 comporte des ouvertures d'entrée d'air 51 et est prolongé à sa périphérie externe par un rebord 55 annulaire globalement d'orientation axiale par rapport à l'axe X-X. Le rebord 55 comporte des ouvertures 53 de sortie d'air et abrite intérieurement le corps 155 du stator portant un chignon 156 implanté radialement entre les pales 570 et les ouvertures 53, qui comportent une partie axiale affectant le rebord 55 et une partie radiale affectant la périphérie externe du fond 56.
Ce chignon 156 appartient au bobinage du stator et porte les sorties des enroulements des phases, qui traversent chacune une partie radiale d'une ouverture 53 ou en variante une ouverture spécifiques réalisée à la périphérie externe du fond 56.
La référence 52 désigne une âme cylindrique centrale délimitant l'ouverture centrale du fond 56 et extérieurement les ouvertures 51 d'entrée d'air. Une capsule 62 est intercalée entre la périphérie externe de la bague externe du roulement 60.

Lorsque le bobinage d'excitation du rotor est alimenté électriquement et que l'arbre 61 tourne, le rotor est magnétisé et un courant alternatif induit est engendré dans le bobinage du stator.

Ce courant induit alternatif est redressé en un courant continu par le dispositif de redressement de courant, pour notamment recharger la batterie du véhicule et alimenter les consommateurs du réseau de bord du véhicule en courant continu.

Une circulation de l'air entre les ouvertures 51 et 53 est réalisée par la rotation du ventilateur 57 pour refroidir le dispositif de redressement ainsi que le bobinage du stator et les roulements à billes.

L'ensemble dispositif de redressement-palier constitue un agencement de redressement de courant, qui comprend :
- un palier 50, ici arrière, appartenant au carter de l'alternateur polyphasé à ventilation interne comprenant plusieurs phases présentant chacune une sortie ;
- un dispositif de redressement de courant alternatif en courant continu porté par le palier 50 et comportant au moins un module 100 comprenant une plaque 10 électriquement conductrice destinée à être reliée électriquement à la sortie de la phase concernée et portant une paire de diodes 93, 94

Le palier 50 est métallique, ici en aluminium ou en variante à base de magnésium. Il est relié électriquement à la masse et à la borne négative de la batterie du véhicule automobile.
Son fond 56 porte à isolation électrique les modules 100, via une pièce électriquement isolante 40, qui est intercalée entre les modules 100 et le fond 56 du palier 50 et qui comporte une ouverture de forme identique à celle de l'ouverture 51 associée au module.

La plaque 10 est prolongée par un dissipateur de chaleur 16 solidaire de la plaque 10, ici à la faveur de vis 92. Ce dissipateur 16 présente une embase 19, prolongée vers l'intérieur par des ailettes 18. Un élément conducteur de chaleur 17 est intercalé entre la face dorsale 102 de la plaque 10 et la face frontale de l'embase 19. L'élément 17 consiste dans un mode de réalisation en une feuille de matière plastique ou en une colle thermo-conductrice. En variante l'élément 17 est thermiquement isolant.
L'air traverse les ailettes 18 situées en vis-à-vis d'une ouverture 51 et c'est pour cette raison que les ailettes sont de longueur différente pour s'adapter à la forme des ouvertures 51. Le module est ainsi bien refroidi.

Les diodes 93, 94, groupées par paire, s'étendent en saillie vers l'extérieur par rapport à la face frontale 103 de la plaque 10. Elles sont dotées d'un culot, comportant une partie principale massive prolongée axialement par un socle présentant une face de fixation pour un élément semi conducteur 200 intercalé entre le socle et la tête d'un élément de connexion en forme de fil rigide appelé queue ou axe de la diode. De la résine enrobe la tête de la queue de la diode et l'élément semi conducteur. Cette résine est solidaire du culot.

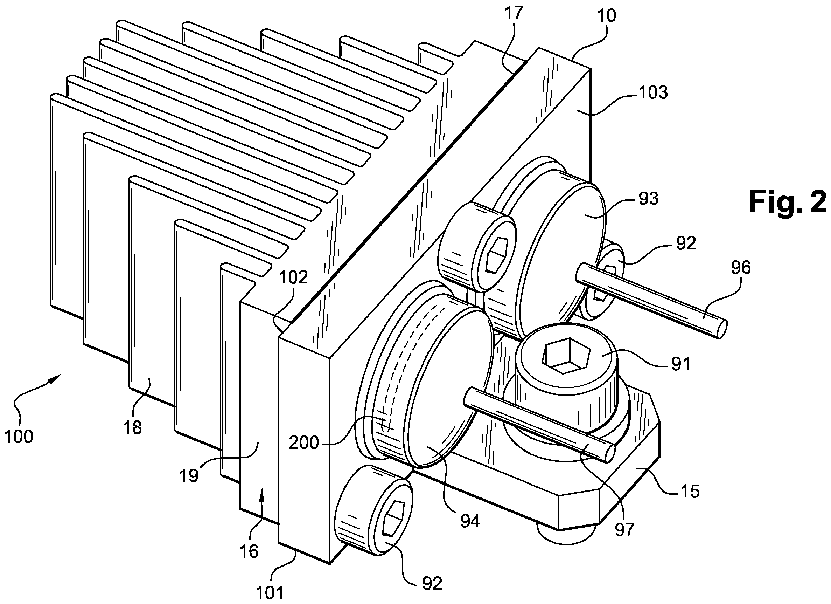

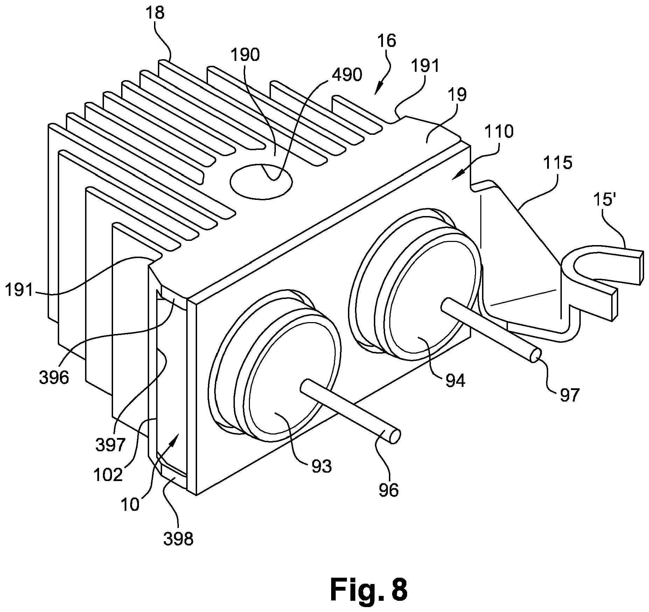

La diode 94 est destinée à être reliée électriquement à la masse via le palier 50 métallique, tandis que la diode 93 est destinée à être reliée électriquement à une borne reliée par un câble à la borne positive de la batterie. Pour plus de précisions on se reportera notamment au schéma électrique de la figure 8 du document FR 2 911 444, sachant que dans cet exemple de réalisation il est prévu six modules (voir figure 2 de ce document).

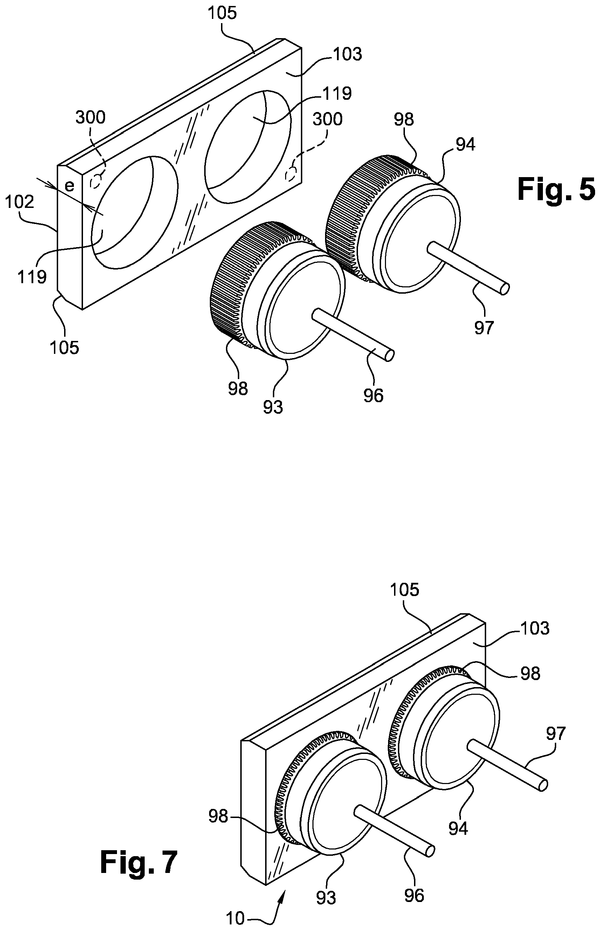

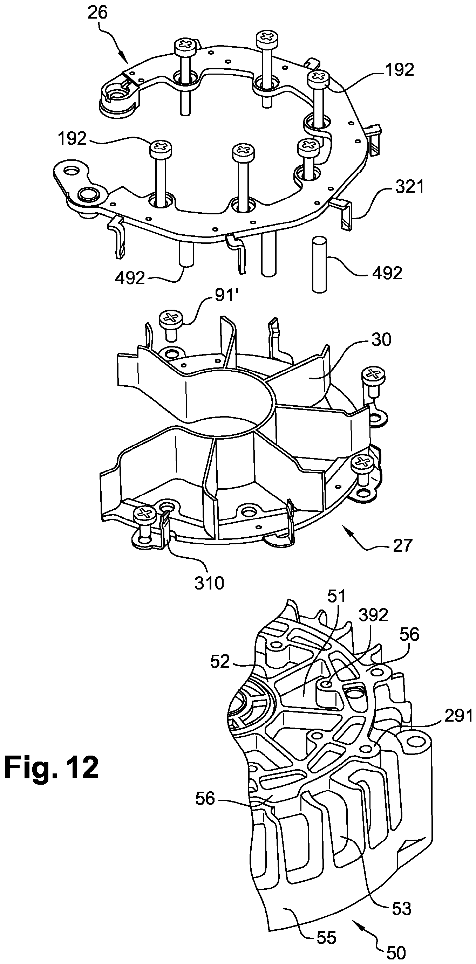

Chaque plaque comporte patte 15 pour sa fixation à l'aide d'une vis 91 au fond 56. La vis travers la patte 15 par l'intermédiaire d'un canon isolant 199 pour se visser dans un trou 150 du fond 56, relié à la masse, tandis que la plaque 10 est reliée à la sortie de la phase concernée traversant de manière connue pour ce faire le fond 56.
La liaison avec une sortie de phase est réalisée à l'aide d'une rondelle ou d'une languette électriquement conductrice (voir figures 7 et 12 de FR 2 911 444).
Il faut donc fixer la plaque sur le dissipateur avec interposition de l'élément 17 conducteur de chaleur, puis fixer la rondelle ou la languette sur la plaque.
Ainsi le montage n'est pas aussi simple que souhaité.

### Objet de l'invention

La présente invention a pour objet de simplifier le montage du module de redressement de courant.

Suivant l'invention un module de redressement de courant pour machine électrique tournante polyphasée à plusieurs sorties de phase, notamment un alternateur ou un alterno-démarreur de véhicule automobile, comprenant une plaque de support électriquement conductrice pour des éléments de redressement de courant, tels que des diodes, d'une phase de la machine électrique tournante, dans lequel la plaque est prolongée par un dissipateur de chaleur doté d'une embase solidaire de la plaque, est caractérisé en ce qu'il comporte une plaquette de phase électriquement conductrice et configurée pour être reliée à la sortie d'une phase de la machine, en ce que la plaque est intercalée entre l'embase et la plaquette moins épaisse que la plaque, en ce que le dissipateur de chaleur, la plaque et la plaquette sont en matériau électriquement et thermiquement conducteur, en ce que l'embase, la plaque et la plaquette sont assemblées ensembles par soudure laser du type par transparence en ce que l'embase comporte une entaille de réception de la plaque et en ce que la profondeur de l'entaille est globalement égale à l'épaisseur de la plaque.

Bien entendu le dissipateur de chaleur, la plaque et la plaquette sont également en matériau soudable par laser. Suivant une caractéristique le dissipateur de chaleur, la plaque et la plaquette sont métalliques. Ils sont par exemple en aluminium où en cuivre.

Une machine électrique tournante du type sus-indiqué est caractérisée en ce qu'elle porte un tel module.

Grâce à l'invention on assemble trois pièces en une seule opération. En outre on supprime l'élément conducteur de chaleur de l'art antérieur et on obtient une bonne conduction électrique et thermique entre les différentes pièces.
De plus l'opération de soudage est très rapide et précise. En outre les risques d'oubli et de perte de la plaquette sont moindres qu'avec une solution de l'art antérieur à languette ou rondelle.

Suivant une caractéristique la plaquette est moins épaisse que la plaque.
Cette plaquette est ainsi relativement mince et donc économique. La minceur de la plaquette facilite le soudage laser par transparence. En outre cette minceur facilite l'assemblage de la plaquette avec sa sortie de phase associée.

Selon d'autres caractéristiques procurant d'autres avantages et prises isolément ou en combinaison :
- l'épaisseur de l'embase est supérieure à l'épaisseur de la plaque ;
- l'épaisseur de la plaquette est inférieure à la moitié de l'épaisseur de la plaque ;
- l'épaisseur de la plaquette est inférieure ou égale à 1,6 mm ;
- l'embase comporte une entaille de réception de la plaque configurée en fonction de la forme de la plaque;
- les éléments de redressement de courant, tels que des diodes, et/ou la plaque sont en contact avec le fond de la cavité ;
- l'entaille de l'embase consiste en une rainure de réception de la plaque ;
- la rainure comporte un fond et deux bords longitudinaux parallèles ;
- la plaque et la plaquette sont globalement de forme rectangulaire ;
- la largeur de la plaquette est supérieure à la largeur de la plaque et de la rainure;
- la longueur de la plaque est égale à la longueur de la plaquette ;
- la soudure laser du type par transparence consiste en des cordons affectant les bords longitudinaux de la plaque, de la plaquette et de la rainure ;
- les cordons sont continus ou segmentés ;
- la plaquette comporte des passages pour le passage les éléments de redressement de courant, tels que des diodes ou des transistors du type MOSFET ;
- les éléments de redressement de courant consistent en des diodes et les passages en des trous ;
- un jeu existe entre les trous et les diodes ;
- la plaquette présente en saillie à l'une de ses extrémités circonférentielle un bras saillant de fixation d'une sortie de phase de la machine ;
- le bras est incliné circonférentiellement ;
- le bras présente à son extrémité libre une patte de sertissage pour fixation de la sortie de phase ;
- l'embase présente une zone centrale élargie pour sa fixation à un palier de la machine.

D'autres avantages apparaîtront à lumière de la description qui va suivre et en référence aux dessins annexés.

### Brève description des dessins

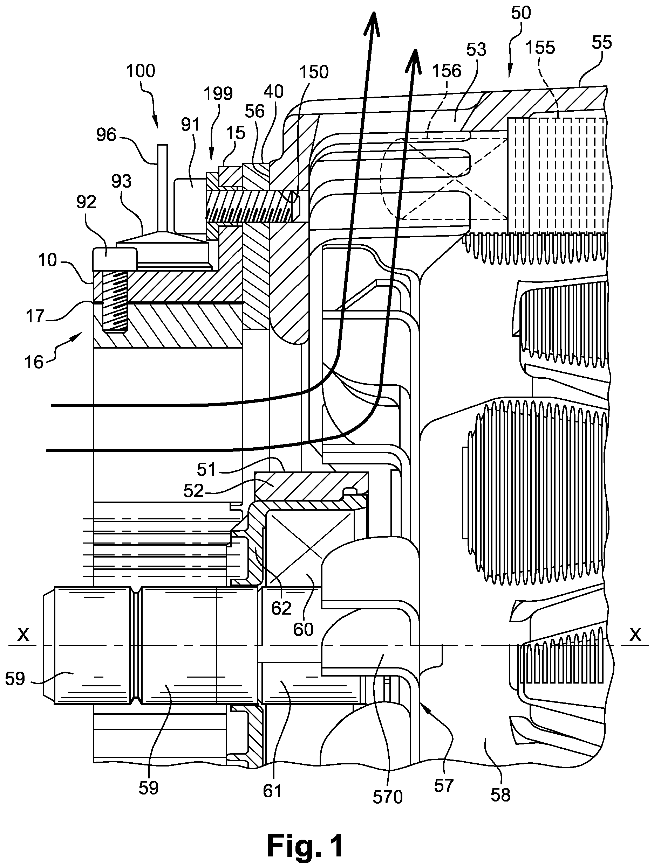

- la figure 1 est une vue partielle en coupe axiale en coupe axiale d'une machine électrique tournante polyphasée selon la demande FR 2 911 444 ;
- la figure 2 est une vue en perspective d'un module de redressement de courant alternatif en courant continu monté sur le fond du palier de la figure 1;

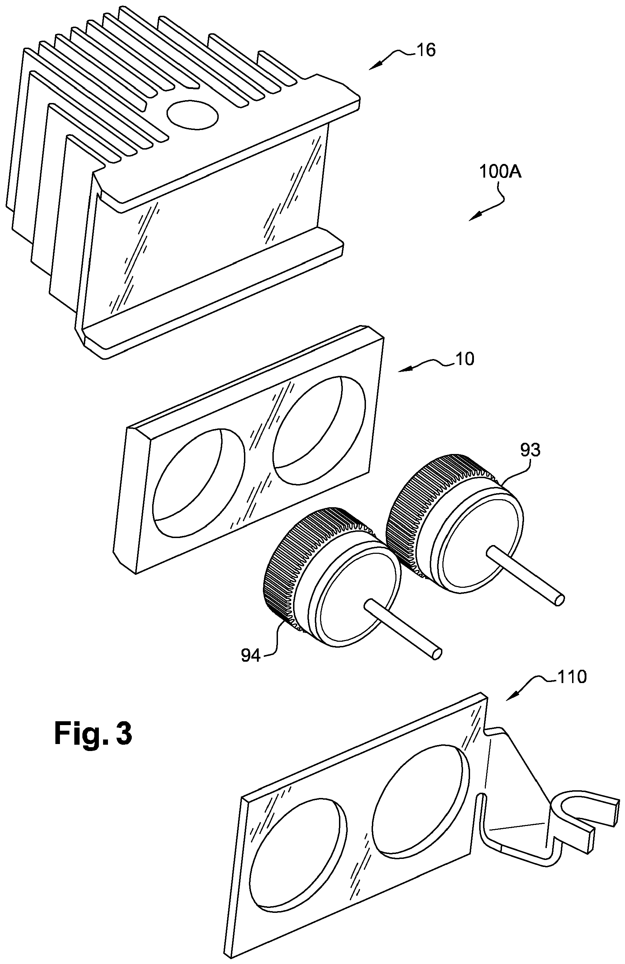

- la figure 3 est une vue en perspective et en éclaté des composants d'un module de redressement de courant alternatif en courant continu selon l'invention ;

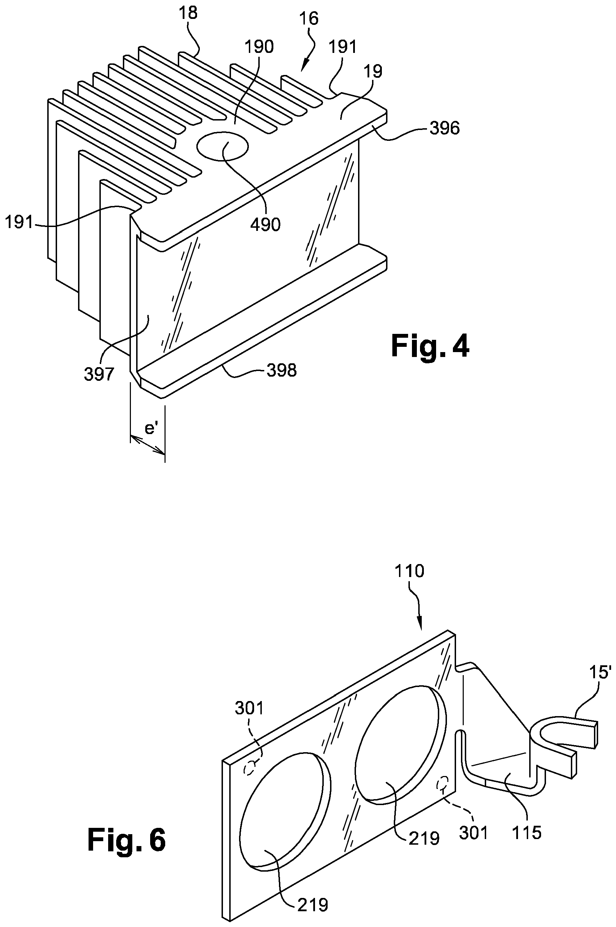

- la figure 4 est une vue en perspective du dissipateur de chaleur métallique de la figure 3 ;
- la figure 5 est une vue en perspective des diodes de redressement de courant et de la plaque métallique de support des diodes de la figure 3;
- la figure 6 est une vue en perspective de la plaquette métallique de fixation d'une sortie de phase de la figure 3;
- la figure 7 est une vue perspective des diodes et de leur plaque de support après l'emmanchement à force des culots des diodes dans les trous de la plaque de support ;
- la figure 8 est une vue en perspective du montage de la plaquette de fixation d'une sortie de phase et de la plaque de support équipée des diodes dans le dissipateur avant l'opération de soudage laser ;

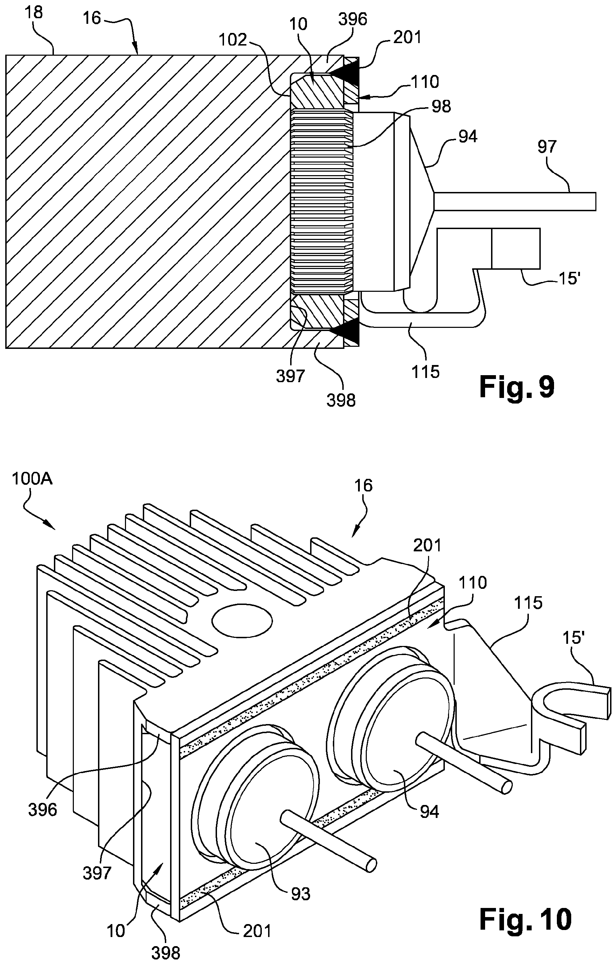

- la figure 9 est une vue en coupe, au niveau de la diode négative non coupée, après l'opération de soudage;
- la figure 10 est une vue analogue à la figure 8 après l'opération de soudage;

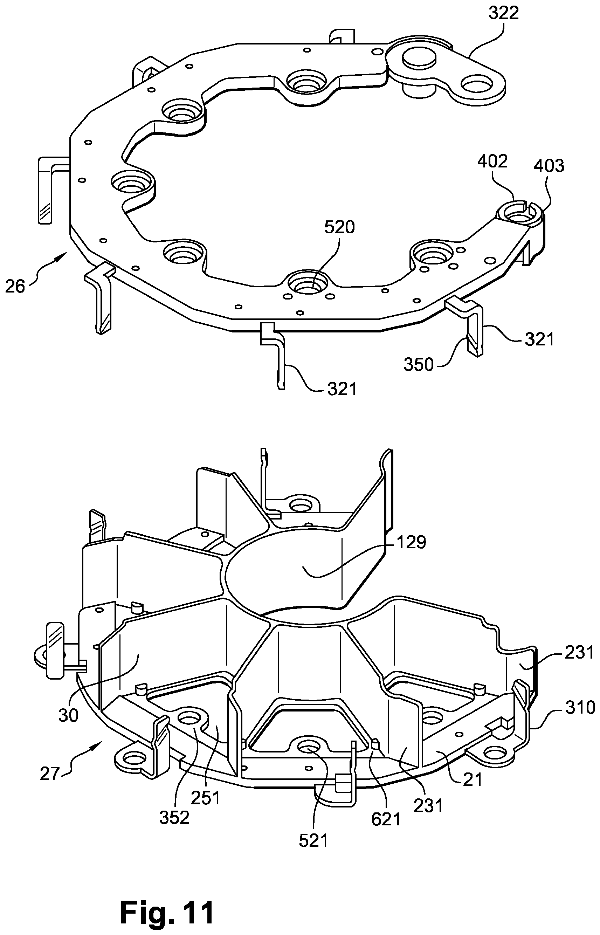

- la figure 11 est une vue en perspective et en éclaté d'un exemple de montage du module de la figure 10 dans un boîtier en deux parties en matière électriquement isolante et moulable ;
- la figure 12 est une vue analogue à la figure 11 avec représentation d'une partie du palier arrière et des divers organes de fixation ainsi que des entretoises entre les deux parties du boîtier.

### Description de modes de réalisation de l'invention

Dans les figures les éléments identiques seront affectés des mêmes signes de référence et les orientations radiale, axiale et transversale seront faites en référence à l'axe X-X de la figure 1. Le terme dorsal désigne la face d'une pièce dirigée vers le fond 56 du palier 50 et le terme frontal la face d'une pièce dirigée en sens opposée au fond 56.

Dans les figures 3 à 10 on a représenté un exemple de réalisation d'un module 100A selon l'invention, qui est dédié au redressement de courant d'une phase de la machine électrique tournante polyphasée et qui se substitue au module 100 de la figure 2. Dans cet exemple la machine électrique tournante polyphasée est donc un alternateur à ventilation interne, notamment pour véhicule automobile, comme dans les figures 1 et 2. Le palier arrière 50 est modifié au niveau de ses ouvertures 51 de manière décrite ci-après ; la structure de l'alternateur étant conservée.

Le module 100A (figure 3) comporte une paire d'éléments de redressement de courant alternatif en courant continu sous la forme de diodes 93, 94 dotées chacune d'une queue 96, 97, comme dans les figures 1 et 2, et suivant une caractéristique trois pièce à savoir :
- un dissipateur de chaleur 16 doté d'une embase 19;
- une plaque électriquement conductrice 10 de support des diodes 93, 94;
- et une plaquette électriquement conductrice 110 de fixation d'une sortie de phase, dite plaquette de phase.

Selon une caractéristique le dissipateur 16, la plaque 10 et la plaquette 110 sont en matériau électriquement et thermiquement conducteur. Ils sont également en matériau soudable à l'aide d'un laser.

Dans cette réalisation le dissipateur 16, la plaque 10 et la plaquette 110 sont métalliques, ici en aluminium, qui est un bon conducteur de la chaleur, tout comme le cuivre.

Suivant une caractéristique la plaquette 110 de phase est configurée pour être reliée à la sortie d'une phase de la machine de manière décrite ci-après.

Suivant une autre caractéristique l'embase du dissipateur, la plaque et la plaquette sont assemblées ensembles par soudure laser du type par transparence. Cette soudure traverse la plaquette 110 (figure 9) moins épaisse que la plaque 10.

Comme visible dans les figures 3 et 8 à 10, la plaque 10 est selon une caractéristique intercalée entre l'embase 19 du dissipateur 16 et la plaquette 110, qui est moins épaisse que la plaque 10.

La fonction électrique du module 100A est réalisée à l'aide des diodes 93, 94, de la plaque 10 et de la plaquette 110, tandis que la fonction de dissipation de chaleur est réalisée principalement par le dissipateur 16 disposé en majeure partie dans le flux d'air.

Ce dissipateur (figure 4) comporte, comme dans les figures 1 et 2, une embase 19 prolongée intérieurement par des ailettes fines 18 d'un seul tenant avec l'embase. Ce dissipateur 16 a une forme globalement trapézoïdale dont la grande base, est constituée par l'embase 19

Les ailettes 18 sont obtenues par exemple par extrusion et s'étendent perpendiculairement à l'embase 19. Elles ont des longueurs décroissantes aux extrémités de l'embase 19 pour donner au dissipateur une forme globalement trapézoïdale adaptée à celle des ouvertures 51 de passage d'air du palier 50, dont certaines sont visibles à la figure 12. Ces ouvertures 51 sont globalement de forme trapézoïdale, et sont délimitées intérieurement par l'âme centrale 52, latéralement par des bras et extérieurement la matière du fond 56. Des passages axiaux d'air sont présents entre deux ailettes consécutives 18, qui sont en correspondance avec une ouverture 51 associée au module 100A.

Les dissipateurs 16 sont ainsi implantés dans le flux axial d'air traversant les ouvertures 51.
Lorsque le rotor de la machine tourne, il y a création d'une circulation de l'air engendrée par la rotation du ventilateur 57 de la figure 1. L'air traverse ainsi axialement les ailettes 18 et les ouvertures 51. Les modules sont ainsi bien refroidis en sorte que la machine électrique tournante polyphasée peut travailler à des températures plus élevées.
Ces ailettes 18 ont, au milieu de l'embase, une longueur constante pour formation d'une zone centrale élargie 190 de l'embase 19. Cette zone 190 est dotée d'un trou 490 cylindrique traversant pour (figure 12) le passage d'un manchon 492 électriquement isolant, ici en matière plastique, traversé par un organe de fixation 192, ici une vis en variante un rivet ou des boulons, pour fixation du module 100A au fond 56.
Chaque module (figures 11 et 12) est destiné à être monté ici dans un boîtier 26, 27 en deux parties électriquement isolantes 26, 27, ici en matière plastique. L'une de ces parties 27, dite partie inférieure, comporte un fond 21 parallèle au fond 56 du palier et est dotée d'ouvertures 251 en correspondance avec les ouvertures 51 du fond 56 de ce palier. Des cloisons 30 s'étendent perpendiculairement au fond 21 et délimitent deux ouvertures 251 consécutives. Ces cloisons 30 sont reliées chacune à leur périphérie interne à une paroi annulaire 129 et à leur périphérie externe à des parois inclinées 231. L'autre partie 26 du boîtier, dite partie supérieure s'étend à la périphérie externe de la partie inférieure 27. Elle recouvre les parois inclinées 231 et forme un couvercle pour la périphérie externe de la partie 27.
Les modules sont montés ainsi chacun dans un logement globalement de forme trapézoïdale délimité par les cloisons 30, le fond 21 ajouré et la partie supérieure 26. Ces logements sont fermés intérieurement par la paroi 129 et ouvert à leur périphérie externe. Les ailettes 18 d'un module sont montées entre les deux cloisons 30 du logement qui sont suffisamment haute pour isoler électriquement et thermiquement les ailettes de deux modules consécutifs.
Le boîtier 26, 27 présente une forme polygonale à sa périphérie externe.
On notera la présence pour chaque logement de deux saillies 621 destinées chacune à coopérer avec une extrémité latérale 191 (figure 4), de la face dorsale de l'embase 19 pour maintenir le dissipateur 16 et le modules 100A dans son logement.
Les parties 26 et 27 comportent des traces électriques noyées dans leur corps en matière plastique et apparentes localement à leur périphérie externe afin de former des bras saillants radialement en forme d'équerre, respectivement, 321 et 310 pour liaison électrique respectivement avec la queue 96 de la diode 93 et la queue 97 de la diode 94. Les parties 26 et 27 forment ainsi des connecteurs respectivement supérieur et inférieur.
Les bras 321 et 322 sont dirigés axialement en sens inverse et sont décalés circonférentiellement. Ces bras présente chacun un pli incliné 350 de fixation des queues des diodes par soudage afin de rattraper les tolérances de la position des queues des diodes 93, 94.
La trace à bras 321 du connecteur supérieur 26 présente également des traces apparentes annulaires pour contact avec les zones élargies 190 du dissipateur, ainsi qu'une languette apparente 332 à l'une de ces extrémités circonférentielle pour sa liaison électrique avec une borne, dite borne B+, reliée via un câble à la borne positive de la batterie. Le connecteur 26 présente également à son autre extrémité circonférentielle deux parties apparentes 402, 403 pour sa liaison avec deux traces apparentes du régulateur de tension comme décrit dans le document FR 2754 650. Pour ce faire les parties 402, 403 appartiennent chacune à une trace reliée électriquement à une zone élargie 190 d'une embase d'un module.
Certains des bras 310 présentent un trou pour le passage d'une vis 91' se vissant dans un trou taraudé 291 du fond 56 pour liaison de la trace avec la masse. En pratique les bras 310 appartiennent à deux traces dont les extrémités circonférentielles sont fixées par des vis 91' dans les trous taraudés 291.
Bien entendu en variante on peut utiliser les dispositions décrites dans le document FR 2 911 444, notamment à la figure 11 de celui-ci ; les bras 310 étant dans ce cas supprimés et remplacés par des saillies portées par le palier 50 concerné. Les queues 97 des diodes négatives 94 sont dans ce cas fixées par soudage, sertissage, encliquetage ou agrafage dans les saillies. Ici il est prévu six logements et donc six sorties de phase. Bien entendu, de manière précitée, cela dépend des applications. Ainsi cinq logements ou quatre logements sont prévus lorsque l'alternateur comporte respectivement cinq et quatre sorties de phase.

Le manchon 492 s'étend en saillie de part et d'autre des faces de la zone élargie centrale 190 de l'embase 19 pour être emmanché dans des trous centraux complémentaires en vis-à-vis 520, 521 (figures 11 et 12) d'un même logement ménagé respectivement dans la partie supérieure 26 et dans le fond 21 de la partie 27.

Les trous 520, 521 appartiennent chacun à une oreille que présente le fond 21 et la partie supérieure 26. Les vis 192 traversent chacune un manchon 492, engagé dans un trou 490, pour se visser dans un trou taraudé 392 du fond 56 afin de fixer le boîtier 26, 27 et les modules 100A, sachant que les manchons 492 forment une entretoise entre le fond 21 et la partie 26. Les saillies 621 empêchent le dissipateur de tourner en sorte qu'un seul trou 490 est nécessaire. Les trous 392 appartiennent à chacun à une oreille que présente centralement l'ouverture 51 concernée à sa périphérie externe. Les ouvertures 51 sont ainsi modifiées par rapport à celles de la figure 1 pour prendre en compte la forme de la zone élargie 190.

Suivant une caractéristique (figures, 4, 8 à 10) la face frontale de l'embase 19 présente une entaille 396-397-398 de réception de la plaque 10, c'est-à-dire un enlèvement de matière pour recevoir la plaque 10. Cette entaille est configurée en fonction de la forme de la plaque 10. La profondeur de l'entaille est globalement égale à l'épaisseur de la plaque.

L'entaille consiste ici en une rainure 396-397-398 de réception de la plaque 10. La rainure est adaptée à la forme de la plaque 10. Cette rainure 396-397-398 est de section en forme de U et est délimitée par un fond 397, appartenant à la face frontale de l'embase 19, et deux bords longitudinaux parallèles 396, 398 perpendiculaire au fond 397. La face frontale de l'embase est donc entaillée pour réception de la plaque 10.

L'épaisseur e de la plaque 10, ici globalement de forme rectangulaire, (figure 5 et 8 à 10) adaptée à la forme de la rainure 396-397-398, est donc selon une caractéristique inférieure à l'épaisseur e' de l'embase 19 (figure 4).

L'épaisseur de la plaque 10 est globalement égale à la profondeur de la rainure 396-397-398, c'est-à-dire à la hauteur des bords 396, 398 de la rainure.

La largeur de la plaque 10 est globalement égale à la distance séparent les deux bords parallèles 396, 398 l'un de l'autre. La longueur de la plaque est globalement égale à celle des bords longitudinaux 396, 398.

On notera que les bords longitudinaux de la face dorsale 102 de la plaque 10 sont dotés chacun d'un chanfrein 105 pour faciliter le montage de la plaque à jeu de montage dans la rainure; ces chanfreins étant adaptés à coopérer avec les bords longitudinaux 396, 398 de la rainure.
La plaque 10 constitue un support, de la paire de diode 93, 94 dotées chacune d'une queue 96, 97. La plaque 10 est donc un porte-diodes.
Les diodes dans un mode de réalisation sont fixées par brasage ou tout autre moyen sur la plaque 10.

Dans ce mode de réalisation économique, la plaque 10 comporte deux trous 119 à savoir un trou 119 cylindrique pour chaque diode. Les culots cylindriques des diodes 93, 94 sont moletés en 198 pour emmanchement à force des diodes dans les trous 119.
La plaque 10 porte ainsi les diodes avec une bonne précision géométrique; les culots moletés 98 étant par leur moletage en prise avec les bords des trous 119.

Ces diodes sont dites diodes du type «press fit».

Selon une caractéristique les culots des diodes affleurent la face dorsale de la plaque en sorte que les fond des culots des diodes 93, 94 sont en contact électrique avec le fond 397 de la rainure comme visible à la figure 9. Un faible jeu existe entre la face dorsale 102 de la plaque et le fond 397 de la rainure.

En variante la face dorsale 102 de la plaque 10 est également en contact avec le fond 397 de la rainure.

En variante la face dorsale 102 de la plaque 10 est en contact avec le fond 397 et un léger jeu existe entre les culots des diodes et le fond 397.

L'épaisseur de la plaque 10 est ainsi globalement égale à la profondeur de la rainure.

Grâce à ces dispositions les diodes 93, 94 sont bien refroidies par les dissipateurs.

Ces diodes sont selon une caractéristique implantées à 90° par rapport aux diodes d'orientation axiale des alternateurs conventionnels ce qui permet de réduire l'encombrement axial comme dans les figures 1 et 2; les queues 96, 97 des diodes étant parallèles au fond 56 et dirigées vers l'extérieur.

De manière précitée la diode positive 93 est destinée, via sa queue 96, à être ici soudée sur un pli 350 incliné de l'extrémité d'orientation axiale d'un bras 321 relié électriquement, de manière précitée, à la borne positive de la batterie du véhicule automobile, tandis que la diode négative 94 est destinée, via sa queue 97, à être soudée sur le pli incliné de l'extrémité axiale d'un bras 310 relié à la masse (figure 11 et 12) via le fond 56 du palier 50.

Les queues 96, 97 sont parallèles aux ailettes 18 et perpendiculaires à la plaque 10 et à l'embase 19.
Les axes des queues 96, 97 sont donc d'orientation transversale par rapport à l'axe X-X de la figure 1 constituant l'axe de la machine et l'axe de rotation du rotor de celle-ci. Cette construction permet de réduire l'encombrement notamment axial du dispositif de redressement de courant à modules 100A appartenant à l'agencement de redressement de courant comportant également ici le palier arrière 50, qui supporte les modules 110A.

En outre grâce aux logements à cloisons 30 la température des diodes 93, 94 est plus homogène d'un module à l'autre.

La plaquette 110 est également globalement de forme rectangulaire. La face dorsale de la plaquette 110 est destinée à venir en contact avec la face frontale 103 de la plaque 10 comme visible dans les figures 8 à 10.

Elle est donc adjacente à la plaque 10 et présente deux passages, ici des trous cylindriques 219 en correspondance avec les trous 119 de la plaque 1 pour chacun le passage du corps moleté de la diode 93, 94 concernée. Ce passage est réalisé avec jeu comme mieux visible à la figure 9 en sorte que les corps moletés des diodes 93, 94 ne sont pas en contact électrique avec la plaquette 110.
La longueur de la plaquette 110 est globalement égale à la longueur de la plaque 10 et de la rainure 396-397-398 comme visible dans les figures 8 et 10.
La largeur de la plaquette 110 est selon une caractéristique supérieure à celle de la plaque 10.
Cette largeur est globalement égale à la largeur de la plaque 10 et de la rainure augmentée globalement de deux fois l'épaisseur d'un bord 396,398 de la rainure comme visible dans les figures 8 à 10.

Cette plaquette 110 est destinée à venir en vis-à-vis des bords 396, 398. La largeur de la plaquette est globalement égale à la largeur de l'embase 19 en étant ici légèrement inférieure à cette largeur (figure 9).

Dans ce mode de réalisation un faible jeu existe entre la plaquette et les bords 396, 398 de la rainure (figure 9) et cette plaquette 110 est en contact avec la plaque 10.

En variante la plaquette 110 est en contact avec les bords 396, 397. Dans ce cas l'épaisseur de la plaque est modifiée, les culots des diodes étant en contact avec le fond 397.
En variante les culots des diodes et/ou la face dorsale de la plaque sont en contact avec le fond 397 de la rainure, tandis que la plaquette 110 est en contact avec les bords 397, 398 et la face frontale de la plaque 10. Tout dépend des applications.

Selon une caractéristique, l'épaisseur de la plaquette 110 étant inférieure à celle de la plaque 10, cette plaquette 110 est configurée pour être reliée à l'une des sorties de phase du stator polyphasé de la machine. La plaquette est plus facile à manipuler que la languette ou la rondelle de l'art antérieur. Les risques de perte ou d'oubli sont minimisés en sorte que la solution selon l'invention est plus fiable.
Cette disposition est avantageuse car elle facilite la liaison entre les sorties des phases d'orientation axiale, comme visible par exemple à la figure 1 du document EP 0515 259 précité, et les plaquettes 110.
Dans un mode de réalisation la plaquette porte d'un seul tenant à sa périphérie interne une patte plus mince, que la patte 15 de la figure 2, pour sa liaison par soudage avec la sortie de la phase

Dans le mode de réalisation représenté chaque sortie d'une phase est reliée à une entrée 15' portée par un bras 115 issue d'une extrémité circonférentielle de la plaquette 110 comme visible par exemple à la figure 6.

L'entrée 15' consiste ici en une patte de sertissage globalement en forme de U, dont les branches constituent des pinces rabattues au contact d'une sortie de phase. Cette sortie de phase est dénudée à son extrémité pour être fixée à la faveur des pinces de la patte 15' serties sur cette extrémité. En variante l'entrée consiste en un bras avec un pli du type des plis 350 pour fixation par soudage des sorties. Bien entendu en variante les bras 310, 321 présentent des pinces comme les entrées 15 pour fixation par sertissage des queues 96, 97 des diodes.

Le bras 115 est d'un seul tenant avec la plaquette 110 et s'étend en saillie à l'extrémité longitudinale de la plaquette adjacente à la diode 94 (figure 8), c'est-à-dire à l'une des extrémités circonférentielle de la plaquette. Ce bras 115 est circonférentiellement saillant. Le bras est moins haut que la largeur de la plaquette 110. L'entrée 15' est d'un seul tenant avec le bras et constitue l'extrémité libre du bras. L'entrée 15', ici sous la forme d'une patte de sertissage, est déformable aisément car l'épaisseur de la plaquette est inférieure à celle de la plaque 10.
Plus précisément dans ce mode de réalisation l'épaisseur de la plaquette 110 métallique est inférieure à la moitié de l'épaisseur de la plaque 10 métallique.
Ici l'épaisseur de la plaquette est de 1 mm et celle de la plaque 10 de 3,5mm. L'épaisseur de l'embase 19 est par exemple de 5,5 mm. Dans cet exemple le diamètre des culots des diodes 93, 94 est globalement égal à 14 mm, la longueur de l'embase 19 est globalement égale à 33, 5 mm et sa largeur globalement de 20 mm. Les bords 396, 398 ont globalement une épaisseur de 1 mm. L'épaisseur de la plaquette 110 est inférieure à la moitié de l'épaisseur de la plaque 10
Tout cela dépend des applications et notamment du diamètre des culots des diodes 93, 94.

En variante l'épaisseur de la plaquette est de 0, 8 mm ou de 1, 6 mm.

Cela dépend également du matériau de la plaquette 110. En effet en variante la plaquette est en cuivre et la plaque 10, ainsi que le dissipateur en aluminium.

En variante le dissipateur 16 et/ou la plaque sont également en cuivre.

Le bras 115 d'un module 100A est incliné circonférentiellement pour épouser la forme de la paroi inclinée 231 du logement du module (figure 11). Cela évite toute interférence entre le bras 310 de fixation de la diode 94 et la patte 15' adjacente. La partie supérieure 26 du boîtier constitue un couvercle de protection pour l'embase 19, la plaque 10, la plaquette 110, les culots des diodes 93, 94 et une partie des queues 96, 97 des diodes d'un module 100A. L'air traverse les ailettes 18, et les ouvertures alignées 251, 51.

A la lumière des figures 7 et 8 on voit que dans une première étape on monte les diodes 93, 94 par emmanchement à force de leur culot moleté en 98 dans les trous 119 de la plaque 10 en sorte que la position géométrique des diodes est bien définie.

Ensuite dans le même lieu de fabrication ou dans un autre lieu de fabrication on monte la plaque 10 équipée des diodes dans la rainure 396-397-398, puis on pose la plaquette 110 sur la plaque (figure 8).

Enfin on vient souder au laser les trois pièces 16-10-110, ici métalliques. Ce soudage laser est un soudage par transparence comme mieux visible à la figure 9.
Le soudage est réalisé ici le long des deux bords longitudinaux 396, 398 de la rainure pour être le plus long possible.
Il laisse apparaître en final deux cordons 201 de soudage le long des bords 396, 398.
La faible épaisseur de la plaquette de phase 110 facilite le soudage laser, qui est rapide et précis.
Ces cordons 201 de soudage laser du type par transparence traversent la plaquette 110 et affectent les bords longitudinaux de la plaquette 110 et par leur pointe, les bords longitudinaux 396, 398 de la rainure et de la plaque 10 comme mieux visible à la figure 9.

Grâce à l'invention la soudure laser assure une connexion électrique entre les composants 16, 93-94, 10 et 110 du module 110A.
Ce soudage assure une bonne conduction de la chaleur entre les composants 16, 93-94, 10 et 110 du module 110A. Ce soudage assure également un maintien mécanique des composants 16, 93-94, 10 et 110 du module 110A.

Ce soudage produit un plaquage mécanique des culots des diodes sur le dissipateur via le fond 397 de la rainure et donc un bon transfert thermique des diodes vers le dissipateur.
Ce soudage crée également une tenue de la plaquette 110 de fixation de la sortie de la phase concernée et donc un plaquage mécanique de la plaquette 110 sur la plaque et/ou le dissipateur, ainsi qu'une bonne conduction de la chaleur.

De manière précitée on a une grande latitude en maîtrisant les différents jeu entre les composants du module 110A notamment en éliminant le jeu, dans un mode de réalisation, entre le fond 397 de la rainure et la plaque 10 alors en contact avec le fond ce qui améliore le transfert de chaleur entre la plaque et le dissipateur.

De même dans un autre mode de réalisation on élimine le jeu entre la plaquette 110 et les bords 396, 398 de l'embase 19 du dissipateur en sorte que la plaquette en contact avec les bords 396, 398 de la rainure ce qui améliore le transfert de chaleur entre la plaquette et le dissipateur.

Le soudage est obtenu par exemple en plaçant le dissipateur et la plaque dans un outil creux pour logement des ailettes ; le dit outil comportant des épaulements pour contact avec les extrémités 191 de la face dorsale de l'embase 19 et des parties verticales pour contact avec l'une des paires des bords latéraux de la plaque 10 et de l'embase du dissipateur 16 et ce sur une hauteur inférieure à la hauteur de l'embase 19.
Un second outil presse la plaquette 110, par exemple par l'intermédiaire d'une vis implantée entre les deux diodes 93, 94, au contact avec la plaque et comporte deux branches latérales pour positionner la plaquette par rapport à la paire des bords latéraux du dissipateur et de la plaque compte tenu du fait que le premier outil est en prise avec le dissipateur et la plaque sur une hauteur inférieure à celle de l'embase.
En variante la plaque présente deux picots saillants destinés à s'engager chacun dans un trou de la plaquette. Dans les figures 5 et 6 on a représenté en pointillés, respectivement en 300 et 301, ces picots et trous. La plaquette 110 est ainsi prépositionnée par rapport à la plaque 10. Toute autre liaison par coopération de formes est envisageable. Le second outil est ainsi simplifié car il assure qu'une fonction de serrage.
Bien entendu en variante on duplique le nombre d'outil pour fixer plusieurs modules. On déplace l'outil à chaque fois sachant que le soudage du type laser est rapide.

Bien entendu la présente invention n'est pas limitée aux exemples de réalisation décrits.

Ainsi en variante la plaque comporte une patte pour sa fixation au fond comme à la figure 2, en sorte que la présence d'une zone élargie 190 et d'un boîtier en deux parties n'est pas obligatoire.

Le module 100A se monte dans ce cas en lieu et place du module 100 des figures 1 et 2.
Bien entendu la plaquette 110 présente alors une échancrure pour le passage de la patte de fixation. Cette échancrure permet de prépositionner la plaquette par rapport à la plaque et ce par coopération de formes.
L'un des cordons 201 est alors en deux parties. Cela est possible car on peut réaliser ces deux parties de cordons par des tirs successifs au laser.

Bien entendu à dans le mode de réalisation de la figure 10 on peut fractionner les cordons en au moins deux parties. Les cordons sont donc continus ou segmentés.

En variante la face frontale de l'embase 19 présente une entaille sous la forme d'une cavité de réception de la plaque permettant de prépositionner la plaque. En effet dans une forme de réalisation la rainure est fermée à chacune de ses extrémités latérales par des bords transversaux parallèles en sorte que la cavité est à contour rectangulaire. Dans ce cas on peut fixer l'embase, la plaque et la plaquette à l'aide de cordons de soudures transversaux. Ces cordons peuvent être associés à au moins une portion de cordon de soudage longitudinal.
En variante la rainure ou la cavité peuvent avoir une autre forme, qui est fonction de la forme de la plaque 10, qui dans tous les cas présente une forme oblongue.

En variante l'embase 19 présente à chacune de ses extrémités longitudinales une zone élargie en sorte que le dissipateur est fixé en deux points sur le palier.

En variante, comme visible à la figure 10 du document FR 2 911 444 précité, le dissipateur 16 de forme trapézoïdale, au lieu d'ailettes 18, comporte des fentes de forme oblongue délimitées par des bandes de matières.

Les ailettes 18, au lieu d'être fines, sont dans un autre mode de réalisation plus épaisses.

Le dissipateur 16 peut avoir encore une autre forme et comporter par exemple une pluralité de trous.

En variante le dissipateur 16 présente un cadre de forme trapézoïdale dans lequel est monté une bande de matière en forme d'accordéon.

Le dissipateur est en variante en cuivre, les ailettes, les fentes, les trous et le cadre étant réalisés par usinage. Bien entendu en variante la plaque 10 et/ou la plaquette 110 sont en cuivre. De préférence dans ce cas le dissipateur 16, la plaque 10 et la plaquette 110 sont en cuivre pour faciliter le soudage laser par transparence. En variante la plaque, la plaquette et/ou le dissipateur sont en alliage de nickel -fer ou de cobalt-fer. La plaquette 110 est en variante en tôle.

En variante on peut créer un module pour redresser le point neutre lorsque les sorties des phases sont connectées en étoile.
La machine électrique peut être en variante de manière précitée sans balais, comme visible dans le document FR 2 744 575, en sorte que la présence du porte-balais n'est pas obligatoire ce qui peut permettre de monter un module supplémentaire.

A la lumière de ce document on voit qu'en variante le dispositif de redressement de courant est porté par le palier avant.
On peut implanter ailleurs le régulateur de tension et donc monter un ou plusieurs modules supplémentaires selon les applications.

En variante les ventilateurs internes sont supprimés et remplacés par un ventilateur externe en sorte que l'air traverse axialement le carter de la figure 1, dépourvu des ouvertures 53, à la faveur des ouvertures 51 réalisées dans les paliers avant et arrière.

En variante, comme décrit dans le document FR 2 744 575, on utilise par la circulation de l'air, une pompe centrifuge qui aspire de l'air à l'intérieur du carter de l'alternateur et le refoule par un canal.

De même l'invention est applicable au cas ou le rotor est un rotor à pôles saillants éventuellement doté d'aimants comme décrit dans le document WO 02/054566.

De même le rotor à griffes peut être assemblé par sertissage à l'arbre et comporter des aimants entre ses dents comme visible à la figure 2 du document FR 2905 806 auquel on se reportera.

Les solutions à aimants augmentent la puissance de la machine et sont compatible avec les modules selon l'invention car ceux-ci sont bien refroidis.

La solution selon l'invention permet de conserver la structure du rotor.

En variante le boîtier 26, 27 est monté sur une mezzanine ajourée portée par le palier 50 comme décrit dans le document WO 2004/040738 précité.

Dans tous le cas le boîtier et donc le dispositif de redressement de courant est porté par le palier avant ou arrière concerné.

On peut inverser les structures en sorte qu'en variante le dispositif de redressement de courant est porté non pas par la face frontale du palier du carter de la machine mais par la face dorsale du palier formant capot de protection.

Dans ce mode de réalisation le palier concerné est allongé axialement et c'est le fond 56 du palier qui porte le logement pour le roulement arrière de l'alternateur ; les bagues collectrices étant implantées en amont du fond 56 et du roulement arrière.

Le carter de la machine peut comporter plus de deux parties. Par exemple le carter peut comporter un palier avant, un palier arrière et une partie intermédiaire portant le stator.

Le ventilateur à action centrifuge 57 de la figure 1 est en variante à action axiale en sorte que la présence des ouvertures 53 n'est pas obligatoire.

La machine est en variante refroidie également par circulation de fluide. Par exemple on peut supprimer le ventilateur avant associé au palier avant et réaliser dans le palier avant un canal de circulation d'un liquide de refroidissement, tel que le liquide de refroidissement du moteur thermique du véhicule.

L'invention est applicable au cas ou la machine électrique tournante est associée à un moteur thermique fixe.

Ainsi qu'il ressort de la description et des dessins les éléments de redressement de courant 93, 94 sont implantés à la périphérie externe du fond 56 du palier concerné, à l'extérieur des ouvertures 51 d'entrée d'air en sorte que ces ouvertures ou ouies du palier sont dégagées et que la longueur radiale des ailettes 18 ou des fentes du dissipateur est transversalement la plus longue possible.

On appréciera la compacité axiale des solutions puisque les queues 96, 97 des diodes 93, 94 sont orientées transversalement vers l'extérieur et non axialement.

Les queues 96, 97 des diodes 93, 94 sont dans les figures de longueur identique. En variante les queues sont de longueur différente. Cela est possible grâce à la configuration des bras 310, 321, qui peuvent être de taille axiale et/ou radiale différente pour s'adapter aux longueurs des queues concernées.

En variante les diodes ne comportent pas de queues.

En effet les bras 310, 321 peuvent être configurés pour s'appuyer directement sur la tête de la diode 93, 94 concernée. Bien entendu l'une des diodes peut présenter une queue et l'autre pas.

Ces diodes peuvent être remplacées par tout autre élément de redressement de courant alternatif en courant continu, notamment par des transistors du type MOSFET lorsque l'alternateur est réversible et consiste en un alterno-démarreur, en sorte que les éléments de redressement de courant ne sont pas forcément des diodes. Ces éléments comportent dans tous les cas un élément semi conducteur.

La machine peut donc être un alterno-démarreur.

Les modules peuvent porter d'autres composants électroniques.

En variante les ouvertures des logements peuvent être différentes d'un logement à l'autre.

Ainsi des logements peuvent présenter des ouvertures de forme trapézoïdale et d'autres modules des ouvertures de forme différentes.

Ainsi qu'il ressort de la description et des dessins le dissipateur 16, la plaque 10 et la plaquette 110 sont en matériau également soudable par laser pour formation d'une soudure laser du type par transparence et la plaquette 110 est plus mince, c'est-à-dire moins épaisse que la plaque 10.

En variante on double le nombre de zone élargie 190 par dissipateur et l'embase 19 présente une zone élargie à chacune de ces extrémités. Il est donc prévu dans ce cas deux manchons 492 et deux trous 520, 521 en vis-à-vis respectivement dans la partie supérieure 26 et dans le fond 21 et ce en correspondance avec des trous taraudés prévus dans le fond 56 du palier 50 pour le vissage des vis 192.

Contrairement à ce qui est divulgué dans le document EP 0 513 197, on assemble ensemble trois pièces 16, 10, 110 électriquement et thermiquement conductrices d'un module de redressement de courant alternatif en courant continu 100A par soudage laser du type par transparence, tandis que dans ce document EP 0 513 197 on assemble, dans une autre application, par soudage laser du type par transparence le couvercle avec le cadre d'un boîtier de circuits électronique de grande taille, ledit boîtier comprenant un fond en céramique brasé sur le cadre.

## Revendications

1. Module de redressement de courant (100A) pour machine électrique tournante polyphasée à plusieurs sortie de phase, notamment un alternateur ou un alterno-démarreur de véhicule automobile, comprenant une plaque de support (10) électriquement conductrice pour des éléments de redressement de courant (93, 94), tels que des diodes, d'une phase de la machine électrique tournante, dans lequel la plaque (10) est prolongée par un dissipateur de chaleur (16) doté d'une embase (19) solidaire de la plaque (10), **caractérisé en ce qu'**il comporte une plaquette de phase (110) électriquement conductrice et configurée pour être reliée à la sortie d'une phase de la machine, **en ce que** la plaque (10) est intercalée entre l'embase (19) et la plaquette (110) moins épaisse que la plaque (10), **en ce que** le dissipateur de chaleur (16), la plaque (10) et la plaquette (110) sont en matériau électriquement et thermiquement conducteur, **en ce que** l'embase (19), la plaque 10) et la plaquette (110) sont assemblées ensembles par soudure laser du type par transparence, **en ce que** l'embase (19) comporte une entaille (396-397-398) de réception de la plaque (10) et **en ce que** la profondeur de l'entaille est globalement égale à l'épaisseur de la plaque (10).

2. Module selon la revendication 1, **caractérisé en ce que** l'épaisseur de la plaquette (110) est inférieure à l'épaisseur de l'embase (19).

3. Module selon l'une quelconque des revendication précédentes, **caractérisé en ce que** les éléments de redressement de courant consistent en une paire de diodes (93, 94) s'étendant en saillie par rapport à la plaque (10) et **en ce que** la plaquette (110) présente deux trous de passage (219) pour chacun passage d'une diode (93, 94).

4. Module selon l'une quelconque des revendication précédentes, **caractérisé en ce que** la plaquette (110) présente en saillie à l'une de ses extrémités circonférentielle un bras (115) de fixation d'une sortie de phase de la machine.

5. Module selon la revendication 5, **caractérisé en ce que** le bras (115) est incliné et présente à son extrémité libre une patte de sertissage (15') pour assurer la liaison électrique par sertissage entre le module (100) et une sortie de phase de la machine.

6. Module selon l'une quelconque des revendications précédentes, **caractérisé en ce que** l'embase présente une entaille sous la forme d'une rainure (396-397-398) de réception de la plaque (10) et **en ce que** les éléments de redressement de courant, tels que des diodes, et/ou la plaque (10) sont en contact avec le fond (397) de la rainure.

7. Module selon la revendication 6, **caractérisé en ce que** la rainure comporte un fond (397) et deux bords longitudinaux (396, 398) parallèles.

8. Module selon la revendication 7, **caractérisé en ce que** la plaque (10) et la plaquette (110) sont globalement de forme rectangulaire et **en ce que** la largeur de la plaquette (110) est supérieure à la largeur de la plaque (10) et de la rainure (396-397-398).

9. Module selon la revendication 8, **caractérisé en ce que** la longueur de la plaque (10) est globalement égale à la longueur de la plaquette (110) et de la rainure (396-397-398).

10. Module selon l'une quelconque des revendications 7 à 9, **caractérisé en ce que** la soudure laser du type par transparence consiste en des cordons (201) affectant les bords longitudinaux de la plaquette (110), de la plaque (100) et de la rainure (396-397-398).

11. Module selon l'une quelconque des revendications 1 à 5, **caractérisé en ce que** l'embase présente une entaille sous la forme d'une cavité de réception de la plaque permettant de prépositionner la plaque.

12. Module selon l'une quelconque des revendications précédentes, **caractérisé en ce que** le dissipateur de chaleur (16), la plaque (10) et la plaquette (110) sont en matériau métallique, tel qu'en aluminium ou en cuivre.

13. Module selon l'une quelconque des revendications précédentes, **caractérisé en ce que** le dissipateur (16) comporte une pluralité d'ailettes issues de son embase (19) et dirigées en sens opposé à la plaque (10).

14. Module selon la revendication 13, **caractérisé en ce que** l'embase présente centralement une zone élargie (190) trouée pour son assemblage à un boîtier (26, 27) ajouré et doté de logement transversaux de réception de modules.

15. Machine électrique tournante polyphasée, notamment un alternateur ou un alterno-démarreur de véhicule automobile, **caractérisée en ce qu'**elle porte un module selon l'une quelconque des revendications 1 à 14.

## Patentansprüche

1. Gleichrichtermodul (100A) für eine mehrphasige, sich drehende elektrische Maschine mit mehreren Phasenausgängen, insbesondere eine Wechselstromlichtmaschine oder ein Wechselstromanlasser eines Automobilfahrzeugs, umfassend eine elektrisch leitfähige Trägerplatte (10) für Gleichrichterelemente (93, 94), wie Dioden, einer Phase der sich drehenden elektrischen Maschine, wobei die Platte (10) durch eine Wärmesenke (16) verlängert ist, die mit einer mit der Platte (10) einteiligen Basis (19) ausgestattet ist,
**dadurch gekennzeichnet, dass** es ein Phasenplättchen (110) umfasst, das elektrisch leitfähig und ausgelegt ist, mit dem Ausgang einer Phase der Maschine verbunden zu sein, dass die Platte (10) zwischen der Basis (19) und dem Plättchen (110) angeordnet ist, das eine geringere Dicke aufweist als die Platte (10), dass die Wärmesenke (16), die Platte (10) und das Plättchen (110) aus einem elektrisch und thermisch leitfähigen Material bestehen, dass die Basis (19), die Platte (10) und das Plättchen (110) miteinander durch Laserschweißen vom transparenten Typ verbunden sind, dass die Basis (19) eine Kerbe (396-397-398) zur Aufnahme der Platte (10) umfasst, und dass die Tiefe der Kerbe insgesamt gleich der Dicke der Platte (10) ist.

2. Modul nach Anspruch 1, **dadurch gekennzeichnet, dass** die Dicke des Plättchens (110) kleiner ist als die Dicke der Basis (19).

3. Modul nach einem der vorhergehenden Ansprüche, **dadurch gekennzeichnet, dass** die Gleichrichterelemente aus einem Paar von Dioden (93, 94) bestehen, die sich in Bezug auf die Platte (10) vorstehend erstrecken, und dass das Plättchen (110) zwei Durchgangslöcher (219) jeweils für den Durchgang einer Diode (93, 94) aufweist.

4. Modul nach einem der vorhergehenden Ansprüche, **dadurch gekennzeichnet, dass** das Plättchen (110) vorstehend an einem seiner Umfangsenden einen Arm (115) zur Befestigung eines Phasenausgangs der Maschine aufweist.

5. Modul nach Anspruch 5, **dadurch gekennzeichnet, dass** der Arm (115) geneigt ist und an seinem freien Ende eine Crimpklemme (15`) aufweist, um die elektrische Verbindung durch Klemmen zwischen dem Modul (100) und einem Phasenausgang der Maschine zu gewährleisten.

6. Modul nach einem der vorhergehenden Ansprüche, **dadurch gekennzeichnet, dass** die Basis eine Kerbe in der Form einer Rille (396-397-398) zur Aufnahme der Platte (10) aufweist, und dass die Gleichrichterelemente, wie Dioden, und/oder die Platte (10) mit dem Boden (397) der Rille in Kontakt stehen.

7. Modul nach Anspruch 6, **dadurch gekennzeichnet, dass** die Rille einen Boden (397) und zwei parallele Längsränder (396, 398) umfasst.

8. Modul nach Anspruch 7, **dadurch gekennzeichnet, dass** die Platte (10) und das Plättchen (110) insgesamt eine rechteckige Form aufweisen, und dass die Breite des Plättchens (110) größer ist als die Breite der Platte (10) und der Rille (396-397-398).

9. Modul nach Anspruch 8, **dadurch gekennzeichnet, dass** die Länge der Platte (10) insgesamt gleich der Länge des Plättchens (110) und der Rille (396-397-398) ist.

10. Modul nach einem der Ansprüche 7 bis 9, **dadurch gekennzeichnet, dass** das Laserschweißen vom transparenten Typ aus Raupen (201) besteht, welche den Längsrändern des Plättchens (110), der Platte (100) und der Rille (396-397-398) zugeordnet sind.

11. Modul nach einem der Ansprüche 1 bis 5, **dadurch gekennzeichnet, dass** die Basis eine Kerbe in der Form eines Hohlraums zur Aufnahme der Platte aufweist, wobei eine Vorpositionierung der Platte gestattet wird.

12. Modul nach einem der vorhergehenden Ansprüche, **dadurch gekennzeichnet, dass** die Wärmesenke (16), die Platte (10) und das Plättchen (110) aus metallischem Material, wie aus Aluminium oder aus Kupfer, sind.

13. Modul nach einem der vorhergehenden Ansprüche, **dadurch gekennzeichnet, dass** die Wärmesenke (16) mehrere Flügel umfasst, die von ihrer Basis (19) ausgehen und in die der Platte (10) entgegengesetzte Richtung weisen.

14. Modul nach Anspruch 13, **dadurch gekennzeichnet, dass** die Basis zentral eine vergrößerte gelochte Zone (190) für ihre Verbindung mit einem Gehäuse (26, 27) aufweist, das perforiert und mit einem transversalen Sitz zur Aufnahme von Modulen ausgestattet ist.

15. Mehrphasige, sich drehende elektrische Maschine, insbesondere eine Wechselstromlichtmaschine oder ein Wechselstromanlasser eines Automobilfahrzeugs, **dadurch gekennzeichnet, dass** sie ein Modul nach einem der Ansprüche 1 bis 14 trägt.

## Claims

1. Current rectifying module (100A) for a polyphase rotating electrical machine with several phase outputs, in particular an alternator or an alternator-starter of a motor vehicle, comprising an electrically conductive support plate (10) for current rectifying elements (93, 94), such as diodes, of a phase of the rotating electrical machine, in which the plate (10) is extended by a heat sink (16) provided with a base (19) integral to the plate (10), **characterized in that** it comprises an electrically conductive phase pad (110) configured to be linked to the output of a phase of the machine, **in that** the plate (10) is inserted between the base (19) and the pad (110) thinner than the plate (10), **in that** the heat sink (16), the plate (10) and the pad (110) are made of electrically and thermally conductive material, **in that** the base (19), the plate (10) and the pad (110) are assembled together by transparent-type laser welding, **in that** the base (19) comprises a notch (396-397-398) for receiving the plate (10) and **in that** the depth of the notch is globally equal to the thickness of the plate (10).

2. Module according to Claim 1, **characterized in that** the thickness of the pad (110) is less than the thickness of the base (19).

3. Module according to either one of the preceding claims, **characterized in that** the current rectifying elements consist of a pair of diodes (93, 94) protrudingly extending relative to the plate (10) and **in that** the pad (110) has two through-holes (219) each for the passage of a diode (93, 94).

4. Module according to any one of the preceding claims, **characterized in that** the pad (110) has, protruding at one of its circumferential ends, an arm (115) for fixing a phase output of the machine.

5. Module according to Claim 5, **characterized in that** the arm (115) is inclined and has, at its free end, a crimping lug (15') for ensuring the electrical link by crimping between the module (100) and a phase output of the machine.

6. Module according to any one of the preceding claims, **characterized in that** the base has a notch in the form of a groove (396-397-398) for receiving the plate (10) and **in that** the current rectifying elements, such as diodes, and/or the plate (10) are in contact with the bottom (397) of the groove.

7. Module according to Claim 6, **characterized in that** the groove comprises a bottom (397) and two parallel longitudinal edges (396, 398).

8. Module according to Claim 7, **characterized in that** the plate (10) and the pad (110) are globally of rectangular form and **in that** the width of the pad (110) is greater than the width of the plate (10) and of the groove (396-397-398).

9. Module according to Claim 8, **characterized in that** the length of the plate (10) is globally equal to the length of the pad (110) and of the groove (396-397-398).

10. Module according to any one of Claims 7 to 9, **characterized in that** the transparent-type laser weld consists of beads (201) touching the longitudinal edges of the pad (110), of the plate (100) and of the groove (396-397-398).

11. Module according to any one of Claims 1 to 5, **characterized in that** the base has a notch in the form of a cavity for receiving the plate making it possible to preposition the plate.

12. Module according to any one of the preceding claims, **characterized in that** the heat sink (16), the plate (10) and the pad (110) are made of metallic material, such as aluminium or copper.

13. Module according to any one of the preceding claims, **characterized in that** the sink (16) comprises a plurality of fins stemming from its base (19) and directed in the direction opposite the plate (10).

14. Module according to Claim 13, **characterized in that** the base centrally has a widened area (190) holed for it to be assembled with an open-work casing (26, 27) provided with transverse housings for receiving modules.

15. Polyphase rotating electrical machine, in particular an alternator or an alternator-starter of a motor vehicle, **characterized in that** it bears a module according to any one of Claims 1 to 14.
